Europäisches Patentamt

European Patent Office

Office européen des brevets

(11) Numéro de publication: **0 201 415 B1**

(12) **FASCICULE DE BREVET EUROPEEN**

(45) Date de publication de fascicule du brevet:
21.11.91

(51) Int. Cl.⁵: **H03M 1/18, G01N 21/27**

(21) Numéro de dépôt: 86400943.6

(22) Date de dépôt: **29.04.86**

(54) Convertisseurs logarithmiques et leur application à la mesure de lumière transmise.

(30) Priorité: 06.05.85 FR 8506820

(43) Date de publication de la demande:
12.11.86 Bulletin 86/46

(45) Mention de la délivrance du brevet:
21.11.91 Bulletin 91/47

(84) Etats contractants désignés:
AT BE CH DE GB IT LI LU NL SE

(56) Documents cités:
EP-A- 0 153 719          FR-A- 2 234 709
FR-A- 2 378 401          GB-A- 2 077 537
GB-A- 2 116 793          US-A- 3 685 047
US-A- 3 700 871          US-A- 4 300 203

PATENTS ABSTRACTS OF JAPAN, vol. 6, no.
104 (P-122) [982], 15 juin 1982, & JP - A - 57
37 250 (NIPPON TECTRON K.K.) 01-03-1982

PATENTS ABSTRACTS OF JAPAN, vol. 5, no.
146 (P-80) [818], 16 septembre 1981; & JP - A
- 56 79 946 (DAINIPPON SCREEN SEIZOU
K.K.) 30-06-1981

(73) Titulaire: **INOVELF, Société anonyme dite:**
**Tour ELF 2 Place de la Coupole La Défense 6**
**F-92400 Courbevoie(FR)**

(72) Inventeur: **Arribard, Hervé**
**4, allée des Iles**
**F-95230 Soisy Sous Montmorency(FR)**
Inventeur: **Cornut, Bruno**
**16 rue du Relais**
**F-64000 Pau(FR)**
Inventeur: **Passade, Gilbert**
**38 rue du Maréchal Foch**
**F-64320 Bizanos(FR)**
Inventeur: **Sesques, Claude**
**4 rue de Longchamp**
**F-64000 Pau(FR)**

(74) Mandataire: **Boillot, Marc**
**SOCIETE NATIONALE ELF AQUITAINE Divi-**
**sion Propriété Industrielle Tour Elf**
**F-92078 Paris la Défense Cédex 45(FR)**

**Description**

La présente invention a pour objet des perfectionnements aux amplificateurs et/ou convertisseurs logarithmiques et les applications de tels dispositifs en particulier aux appareils analyseurs photométriques.

Dans de telles applications comme dans de nombreuses autres bien connues de l'art antérieur, on se réfère à une variable que l'on détecte et/ou que l'on mesure, fonction exponentielle de celle que l'on désire à la sortie, d'où le recours à des amplificateurs logarithmiques placés en aval des détecteurs ou des capteurs. Or de plus en plus, on recherche des sorties numérisées ce qui permet des affichages numériques et/ou l'accès à des calculateurs et/ou tous autres dispositifs traitant des données numériques.

Lorsqu'on utilise des amplificateurs logarithmiques analogiques, il devrait donc suffire théoriquement de les faire suivre par un convertisseur analogique/numérique (CA/N) mais ceci impose une très grande précision à l'amplificateur logarithmique ce qui n'est généralement pas le cas, sauf à des coûts disproportionnés avec l'usage que l'on veut en faire.

Pour illustrer les problèmes qui se posent, on peut se référer à titre d'exemple à la mesure de la transmission lumineuse d'un échantillon. Si $I_0$ est l'intensité de la lumière à l'entrée de l'échantillon fluide, et I l'intensité à la sortie, la loi de Beer-Lambert s'écrit :

$$I = I_0 \exp(-tC) \quad (1)$$

étant le coefficient dit d'extinction moléculaire, t la longueur de la traversée de l'échantillon par la lumière et C la concentration du chromogène d'où :

$$C = \frac{-1}{t} \, \text{Log} \, \frac{(I)}{(I_0)} \quad (2)$$

En fait ce calcul est idéal ; compte tenu des réflections et des pertes, la formule est plus complexe mais aboutit toujours à peu de chose près à :

$$C = A\text{Log}(I) + B \quad (3)$$

où A et B sont des constantes.

Si donc on mesure la lumière transmise I à l'aide d'un capteur, par exemple un détecteur optoélectronique qui émet un courant i variant linéairement avec I, on cherche, à la sortie de l'ensemble électronique un signal S représentant la valeur de C de la forme :

$$S = a\text{Log}(i) + b \quad (4)$$

où a et b sont des constantes.

Or avec les amplificateurs logarithmiques de l'art antérieur, traduisant l'équation (4) on doit régler a et b ainsi que la linéarité de S en fonction de Log (i) qui n'est jamais parfaite, a fortiori si l'on veut convertir les données analogiques en données numériques. Des dérives apparaissent en particulier dans le temps.

De plus, les amplificateurs analogiques classiques empêchent de mesurer les signaux en dessous d'un certain seuil et rendent impossibles des mesures de noir (de zéro).

De plus il faut souligner que lorsque la linéarité n'est pas exactement assurée, non seulement la prise en compte de l'erreur sur S est importante mais également celle sur la pente qui s'écarte de celle de la droite représentant S en fonction de Log (i). Il se peut en effet que, dans certaines gammes de signaux, la valeur de S soit peu différente de sa valeur idéale, voire égale à cette dernière, mais que celle de la dérivée soit au contraire nettement différente. Il apparaît donc que, dans des applications comme les mesures photométriques de variations d'absorption lumineuse, on travaille sur des variations de signaux et, plus que les écarts sur la fonction logarithmique elle-même, ce sont les écarts sur sa dérivée qui peuvent devenir prohibitifs.

La présente invention a donc pour but de réaliser des ensembles assurant l'amplification, la transformation logarithmique et la conversion analogique/numérique. Or si jusqu'à présent on a assuré les deux premières opérations dans des amplificateurs logarithmiques, et la dernière dans un convertisseur, on conçoit qu'il est possible d'assurer une amplification linéaire puis la conversion analogique/numérique et enfin la transformation logarithmique dans un calculateur numérique c'est-à-dire essentiellement dans un microprocesseur.

En faisant remonter en amont la conversion analogique/numérique on s'affranchit de l'incertitude sur la transformation logarithmique. Il suffirait alors de s'assurer de la linéarité du transformateur.

Mais on se heurte à un problème de prix de revient de convertisseur analogique/numérique qui est très lié à sa capacité. Si les CA/N à 12 bits (pouvant donc convertir $2^{12} = 4096$ niveaux de signal différents) sont courants et de prix accessibles, au delà de 12 bits les convertisseurs se raréfient et deviennent de plus en plus coûteux. Si l'on a besoin de traiter par exemple de l'ordre de 500.000 niveaux de signal différents on devrait recourir à un convertisseur à 19 bits ($2^{19} = 524.288$) ce qui pose les problèmes qui viennent d'être énoncés.

Selon l'invention, on va recourir à un amplificateur linéaire à changement de gain commandé par le microprocesseur ou équivalent, de façon à maintenir le convertisseur recevant les signaux de l'amplificateur, en dessous de la saturation.

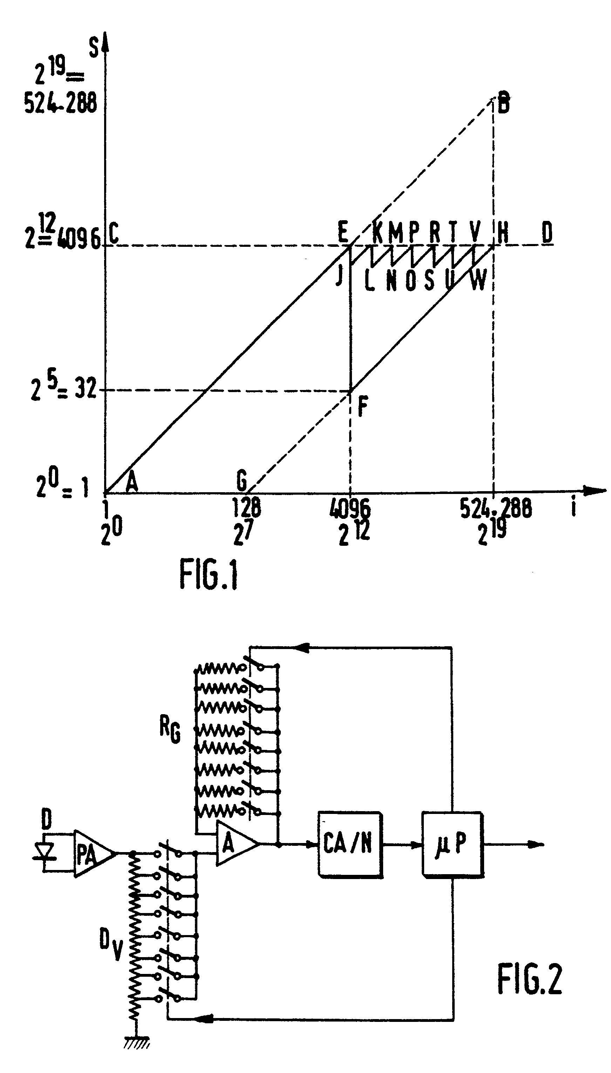

Pour illustrer ce propos, en revenant à l'exemple du CA/N à 12 bits alors qu'on désire travailler jusqu'à 19 bits, on se reportera à la figure 1 ( en coordonnées logarithmiques).

Si i est le courant reçu par l'amplificateur en provenance du détecteur et S le signal transmis par l'amplificateur au convertisseur, on devrait idéalement travailler le long de la droite AB c'est-à-dire pour i et S variant de 1 à $2^{19}$, mais la droite CD d'ordonnée $2^{12}$ correspond à la saturation du convertisseur. On ne peut donc amplifier qu'entre A et E c'est-à-dire en se limitant à $2^{12}$ soit 12 bits. Si donc, parvenant en E, on change le gain de l'amplificateur on peut revenir par exemple au point F de la droite GH parallèle à AB : G sur l'axe des i correspond à 7 bits (128) ; H sur la droite CD de saturation correspond à $2^{19}$ pour i et $2^{12}$ soit 12 bits pour S. On conçoit donc que l'on peut travailler le long de AE jusqu'à la limite de saturation, puis abaissant le gain de l'amplificateur, on revient en F ($2^{12}$ pour i, $2^5$ soit 32 bits pour S) pour remonter vers H ($2^{19}$ pour i, et $2^{12}$ soit 12 bits pour S, c'est-à-dire dans les limites recherchées aussi bien pour i que pour S).

Mais si en E la résolution est de 1/4096, en F elle est de 1/32 ce qui est trop défavorable. On peut donc imaginer plusieurs changements de gain et travailler par exemple le long de EJKLMNPQRSTUVWH.

Dans le cas de suivi dans le temps d'un signal, on peut être amené à suivre divers chemins par exemple pour se garantir contre les changements de gains qui pourraient gêner, comme on le verra dans un exemple ci-après.

Mais, même en recourant à un tel système, subsiste une incertitude sur l'exactitude des différents gains d'où l'utilité dans certaines applications d'un contrôle qui sera assuré, conformément à l'invention par un système d'autoétalonnage assurant contrôles et rectifications avant chaque série d'opérations. On peut également envisager de les faire lors de chaque changement de gain.

Les documents US-A-3,685,047 et Patents Abstracts of Japan Vol. 6, No. 104, page 122 (982) décrivent chacun un convertisseur analogique/numérique destiné à transformer des signaux analogiques en signaux logarithmiques numériques. Le document Patents Abstracts of Japan, Vol. 5, No. 146, page 80 (818) décrit un amplificateur logarithmique destiné à être utilisé dans un densiomètre optique.

La présente invention a pour but de fournir un dispositif d'amplification et de calcul de conversion analogique/numérique qui est particulièrement adapté à un appareil analyseur photométrique.

Pour ce faire, l'invention propose un dispositif d'amplification et de calcul de conversion analogique/numérique transformant des signaux analogiques en signaux logarithmiques numériques comprenant un amplificateur linéaire à gain programmable suivi d'un convertisseur analogique/numérique et d'un calculateur, ledit calculateur assurant la transformation logarithmique du signal de sortie du convertisseur analogique/numérique et modifiant le gain de l'amplificateur dès que son signal de sortie atteint les limites de saturation ou de résolution acceptable du convertisseur A/N caractérisé en ce qu'il comporte un système générateur de tensions de référence V connectable par le calcualteur à l'entrée de l'amplificateur entre chaque phase de fonctionnement ou à chaque changement de gain, les signaux de sortie dudit amplifcateur, résultant de la tension de référence V et des gains successifs $g_i$, $g_{i+1}$, et les rapports $Vg_i/Vg_{i+1}$ calculés par le calculateur étant mis en mémoire à titre d'autoélatonnage pour corriger les mesures pendant la phase de fonctionnement.

Pour mieux faire comprendre les caractéristiques techniques et les avantages de la présente invention, on va en décrire des exemples de réalisation et d'application étant bien entendu que ceux-ci ne sont pas limitatifs quant à leur mode de mise en oeuvre et aux applications qu'on peut en faire. On se référera aux figures suivantes qui représentent schématiquement :

la figure 1, un diagramme des variations de gain en fonction des signaux d'entrée ;

la figure 2, un schéma de principe de circuit conforme à la présente invention dont un mode de réalisation plus précis sera décrit ci-après figure 4 ;

la figure 3, un tableau à deux entrées : gain de l'amplificateur et atténuation du diviseur de tension ;

la figure 4, un schéma de réalisation plus détaillé du circuit de la figure 2 ;

la figure 5, un schéma d'ensemble d'application à l'analyse par mesure de transmission de lumière par un échantillon ; et

la figure 6, un diagramme des variations des signaux de sortie S en fonction des signaux d'entrée i, dans le cas de cette dernière application.

La chaîne de détection et de calcul comprend essentiellement un détecteur, capteur ou équivalent D, un préamplificateur linéaire PA, un amplificateur linéaire A un convertisseur analogique/numérique CA/N et un microprocesseur $\mu$P.

Le gain de l'amplificateur A est programmé grâce à une batterie de résistances $R_G$ mises en circuit grâce à des commutateurs commandés électroniquement par le microprocesseur $\mu$P.

En amont de l'amplificateur A peut être disposé un diviseur de tension fonctionnant en atténuateur programmé grâce à des commutateurs commandés électroniquement par le microprocesseur $\mu$P.

Grâce aux résistances $R_G$ on peut donc modifier le gain de l'amplificateur A c'est-à-dire (en se reportant à la figure 1) choisir de se placer sur l'un ou l'autre des segments AE, JK, LM, NP, QR, ST, UV ou WH ou leur prolongement vers le bas (sauf pour AE bien entendu).

En phase de mesure, les signaux passent directement du préamplificateur linéaire PA à l'amplificateur A dont le gain va être modifié sur ordre du microprocesseur $\mu$P grâce aux commutateurs électroniques sélectionnant les résistances $R_G$ correspondant aux différents gains de façon à travailler par exemple selon AEJKLMNPQRSTUVWH de la figure 1 voire AEFH ou toute autre combinaison de changements de gain permettant de rester sous le seuil de saturation du convertisseur CA/N.

Par conséquent dès que le microprocesseur reçoit des signaux soit dépassant vers le haut le seuil de saturation, soit atteignant vers le bas la valeur choisie pour ne pas perdre en résolution comme indiqué plus haut, il donne ordre de changement de gain et ainsi de suite à chaque retour audit seuil ou à ladite valeur.

Le microprocesseur $\mu$P, recevant du convertisseur CA/N des données numérisées, assure de plus la transformation logarithmique en utilisant d'une part les valeurs de rapports de gains portés en mémoire et d'autre part un algorithme de calcul logarithmique enregistré en mémoire morte.

Si l'on utilise le diviseur de tension, les valeurs de rapports de gains sont enregistrées en mémoire vive comme il résulte des opérations qui seront décrites ci-après. Dans le cas contraire, ces valeurs peuvent être enregistrées en mémoire morte.

Dans le cas de l'application aux mesures photométriques à but analytique, la connaissance du rapport des gains est en effet suffisante puisque les méthodes utilisées, qu'elles soient cinétiques ou à point final, sont basées sur des mesures de différences de concentration à des instants différents, donc sur des mesures de rapports de signaux à des instants différents (voir formule (2)). Un autoétalonnage absolu de l'appareil est possible sans avoir recours à une référence elle-même absolue et stable dans le temps. Il suffirait donc de mesurer n'importe quelle tension V aux différents gains et de calculer le rapport entre signaux de sortie de l'amplificateur A pour toutes paires de gains successives :

$$\frac{Vg_i}{Vg_{i+1}}$$

Mais une seule valeur de V peut être insuffisante pour assurer une bonne précision de mesure pour chacune de ces paires de gains. Aussi, le circuit à diviseur de tension programmable permet de sélectionner à l'entrée de l'amplificateur A des tensions $V_i$ bien adaptées à chaque paire de gains.

Avant une opération de mesure, le microprocesseur $\mu$P commandant le diviseur $D_V$ grâce à ses commutateurs électroniques sélectionne une tension $V_i$ et va mesurer le rapport entre signaux de sortie de l'amplificateur A pour deux gains successifs c'est-à- dire :

$$\frac{V_i g_i}{V_i g_{i+1}}$$

ce qui permet de mettre en mémoire vive les valeurs de rapport de gain ainsi contrôlées et de faire apporter les correctifs nécessaires par le microprocesseur.

On notera d'ailleurs avant de détailler le fonctionnement de ce système que l'on pourrait se référer non à un diviseur de tension mais à une ou plusieurs tensions de référence.

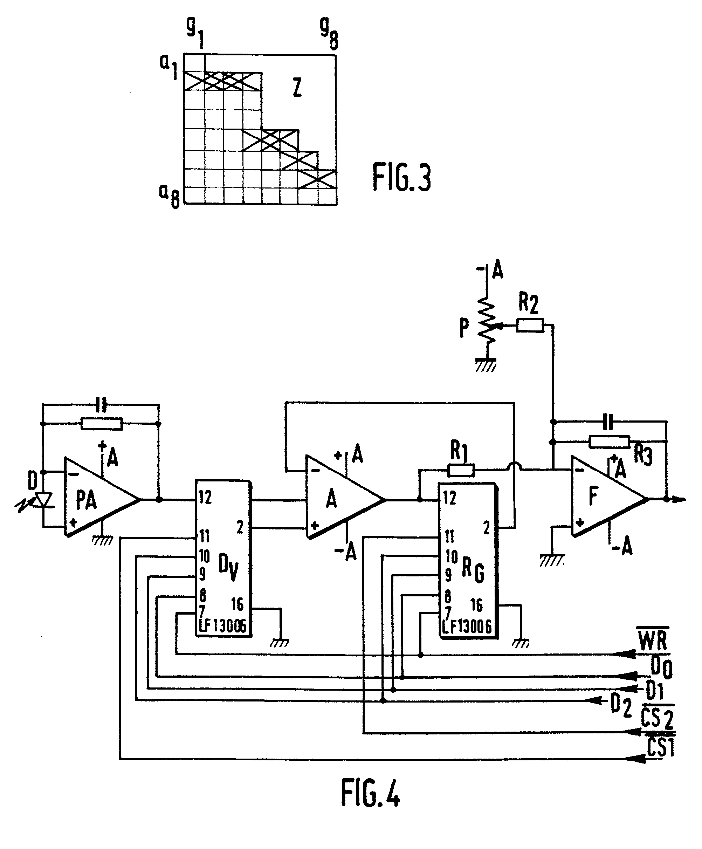

On va étudier le fonctionnement en se reportant à la figure 3 qui représente en tableau carré les différents gains $g_1$ à $g_8$ de l'amplificateur A et les atténuations $a_1$ à $a_8$ du diviseur de tension $D_V$, correspondant de préférence à des divisions successives de la tension par 2, 4, 8, 16, etc...

On notera que l'on doit éliminer une zone Z du tableau qui correspondrait à des saturations. Une ligne brisée a été tracée ici, à titre d'exemple, pour limiter cette zone. Une façon pratique de procéder est de mesurer pour chaque atténuation $a_i = \frac{V}{V}i$ du diviseur $D_v$ le signal S pour chacun des gains $g_i$ du réseau $R_G$. On va donc de préférence se placer dans deux cases horizontalement voisines du tableau de la figure 1, chaque paire étant indiquée par un X en cherchant les conditions les plus favorables de résolution.

Dans une version légèrement différente, et si l'application le demande, on peut étendre encore la dynamique du système en utilisant le diviseur de tension programmée $D_v$, non plus seulement dans une fin d'autoétalonnage de la chaîne de conversion mais également pendant la mesure afin d'atténuer plus ou moins le signal de sortie du préamplificateur PA, si le besoin s'en fait sentir. Dans une telle application, les signaux les plus faibles sont mesurés en fixant l'atténuation à sa valeur minimum (soit la valeur 1 : quand la sortie du préamplificateur PA est reliée directement à l'entrée de l'amplificateur A) et en faisant varier les gains de l'amplificateur A en agissant sur le réseau $R_G$, et les signaux les plus forts sont mesurés en fixant le gain de A à la valeur la plus faible pouvant être obtenue avec $R_G$ et en faisant varier l'atténuation en agissant sur le réseau diviseur $D_v$. Tout autre combinaison des valeurs d'atténuation, par action sur $D_v$, et de gain, par action sur $R_G$, est bien sûr envisageable. Si la plus grande précision est nécessaire, la connaissance la plus exacte possible des rapports des facteurs d'atténuation successifs délivrés par $D_v$ est indispensable. Ils peuvent être obtenus à partir du tableau de la figure 3 en calculant les rapports des valeurs de ce tableau contenues dans deux cases verticalement voisines en cherchant, pour une paire de facteur d'atténuation successifs donnés, les conditions les plus favorables de résolution.

Il est évident, que compte tenu de l'évolution technique présente, on peut réaliser un circuit tel celui de la figure 2 en faisant appel à des composants usuels et notamment à des circuits intégrés. On a représenté à la figure 4 un mode de réalisation illustrant le recours pour le diviseur de tension et pour la batterie de résistances de variation de gain à deux circuits intégrés LF 13006 de National Semiconductor.

Ces circuits comprennent essentiellement une série de résistances entre lesquelles on peut se connecter grâce à 8 commutateurs électroniques commandés par un décodeur à 3 bits.

On retrouve à la figure 4 sous les mêmes références les éléments de la figure 2, les deux circuits intégrés jouant respectivement le rôle du diviseur de potentiel $D_v$ et de la batterie de résistances $R_G$ de changement de gain.

L'ensemble peut être suivi d'un filtre F passebas.

La figure 4 ne représente que quelques alimentations + A et - A et omet pour alléger le dessin un certain nombre de composants ou connections classiques ne faisant pas partie de l'invention.

Les signaux issus du préamplificateur recevant lui-même ceux du détecteur D ou autre capteur, arrivent au circuit $D_v$ par l'entrée 12. Sa sortie 2 est connectée à l'entrée + de l'amplificateur A dont la sortie est elle-même reliée à l'entrée 12 du circuit $R_G$ dont l'entrée 2 est reliée à l'entrée - de l'amplificateur A.

La sortie de l'amplificateur A est également reliée par une résistance $R_1$ à l'entrée du filtre F dont l'entrée + est à la masse. Sur l'entrée - du filtre F est également ajoutée par l'intermédiaire de la résistance $R_2$ une tension négative réglée grossièrement par le potentiomètre P, qui décale vers le haut les signaux en sortie de F, assurant que ces signaux seront toujours strictement positifs, de façon à pouvoir être convertis efficacement par le convertisseur analogique/numérique. Dans une version préférée, les résistance $R_1$, $R_2$ et $R_3$ sont choisies égales entre elles et sont prises sur les broches 13, 14 et 15 restant disponibles des réseaux $R_G$ et $D_v$.

La sortie du filtre F est connectée au convertisseur analogique/numérique CA/N de la figure 2 non représenté à la figure 4 lequel est suivi du microprocesseur $\mu$P de la figure 2 non représenté à la figure 4.

Les deux circuits intégrés sont commandés par le microprocesseur dans les conditions suivantes : leurs entrées 8, 9 et 10 reçoivent les trois bits de sélection $D_0$, $D_1$, $D_2$, du microprocesseur, les entrées 7 recevant l'ordre WR de prise en compte du gain (pour $R_G$) ou de l'atténuation (pour $D_V$) la sélection entre gain ou atténuation étant commandée respectivement par $CS_1$ ou $CS_2$. Le faisceau WR, $D_0$, $D_1$, $D_2$, $CS_1$, $CS_2$ provient du microprocesseur $\mu$P.

Le préamplificateur PA peut être réalisé par exemple à l'aide d'un circuit 3528 CM de Burr-Brown, l'amplificateur A à l'aide d'un 547 KH et le filtre F d'un OP 07EH tous deux d'Analog Device.

Comme on l'a souligné plus haut on peut, si cela est rendu possible par le contexte, remplacer le diviseur $D_V$ par une ou plusieurs tensions de référence.

Il est évident que des ensembles d'amplification et de conversion logarithmique et analogique/numérique trouvent d'innombrables applications notamment à des appareils de mesure classiques de tension et/ou d'intensité en leur apportant l'avantage de l'autoétalonnage et de la sortie numérique permettant l'affichage en clair et la connection à tout dispositif de traitement des données obtenues.

Comme on l'a déjà longuement mentionné des dispositifs conformes à l'invention trouvent une application particulièrement bien adaptée aux problèmes à résoudre dans le domaine de l'analyse par mesure de la transmission lumineuse.

Considérons à titre d'exemple l'application à un dosage biologique mettant en jeu une réaction enzymatique se traduisant par l'apparition ou la disparition d'un chromogène. Il s'agit de suivre la variation dans le temps de la concentration du chromogène en mesurant la variation de l'intensité de la lumière transmise à la longueur adéquate à travers une cellule optique dans laquelle la réaction enzymatique se développe (méthode cinétique ou méthode "en point final"). La formule (2) montre bien qu'une différence de concentrations de chromogène entre deux instants se traduit par un rapport d'intensité lumineuse et, par conséquent, utilisant un dispositif électronique de mesure à gain, et éventuellement à atténuation, programmable du type précédemment décrit, la connaissance précise des rapports des gains (et éventuellement des facteurs d'atténuation) est nécessaire, plus que la connaissance des valeurs absolues de ces gains et de ces facteurs d'atténuation.

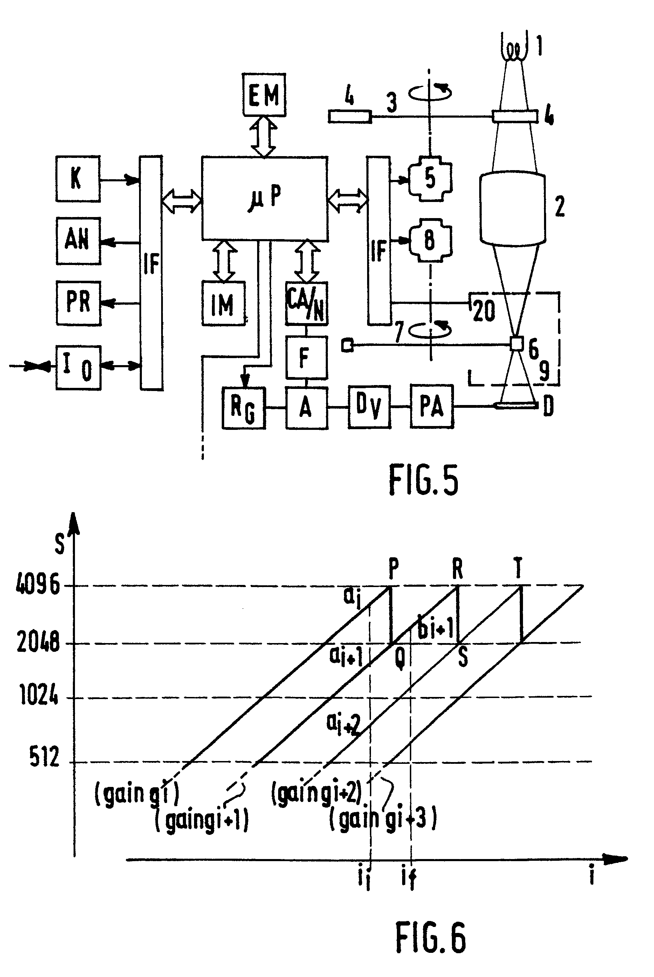

Dans une telle application, la difficulté majeure réside dans la mesure des réactions de faible amplitude, pour lesquelles la précision absolue demandée sur le rapport

$$\frac{i_f}{i_i}$$

entre le signal $i_f$ délivré par le détecteur en fin de réaction et le signal $i_i$ délivré par le détecteur début de réaction doit être très bonne. Or, avec le système précédemment décrit, tout changement de gain intervenant pendant le cours du déroulement de la réaction est source d'erreur, même si les rapports entre ces gains sont connus, ou ont été mesurés au préalable, avec la plus grande précision possible. Il est donc nécessaire de concevoir une méthode de sélection des gains par le microprocesseur qui élimine le risque de changement de gain en cours de réaction si cette réaction est de faible amplitude et ce même si le sens de la réaction (i augmente ou diminue dans le temps) et l'ordre de grandeur de l'amplitude (petite ou grande) de la réaction ne sont pas connus à priori. La difficulté et une façon d'y remédier sont illustrées sur la figure 6 qui est un agrandissement de la figure 1 dans une gamme de signaux choisie à titre d'exemple.

Pour illustrer le raisonnement, on considère le cas d'une réaction se traduisant par une disparition de chromogène donc par une augmentation de signal ($i_f > i_i$). On suppose d'autre part que les gains consécutifs sont dans un rapport très proche de 2, ce qui est le cas quand on utilise les circuits LF 13006 de National Semiconductor. On choisit enfin que la résolution minimum tolérable sur la mesure soit de l'ordre de 1/500, ce qui limite la plage de signal i mesurable sur chaque gain à une valeur de S comprise entre 512 (limite de résolution tolérable) et 4096 (limite due à la saturation). Dans ces conditions la valeur initiale $i_i$ du signal peut en principe être mesurée sur l'un ou l'autre des trois gains consécutifs $g_i$, $g_{i+1}$, $g_{i+2}$, ce qui donnerait respectivement les trois valeurs de signal S : $a_i$, $a_{i+1}$ et $a_{i+2}$. La valeur $a_i$ mesurée sur le gain $g_i$ donne en principe la meilleure mesure absolue de $i_i$ car la résolution sur $a_i$ est meilleure que $a_{i+1}$ et $a_{i+2}$. Mais, si l'on choisit ce gain $g_i$ pour mesurer $i_i$, on court le risque d'avoir à mesurer le signal final $i_f$ sur le gain $g_{i+1}$ si la valeur $i_f$ est au delà de la limite de saturation sur le gain $g_i$. Ceci peut en effet se produire même avec des signaux $i_i$ et $i_f$ très voisins si, par malchance, $i_i$ et $i_f$ se situent de part et d'autre du niveau correspondant aux points P et Q. Alors, le signal $i_f$ se mesurera sur le gain $g_{i+1}$ et donnera le signal $b_{i+1}$ et l'erreur inévitable due au changement de gain $g_i \rightarrow g_{i+1}$ se répercutera avec un maximum d'effet sur la mesure

$$\frac{b_{i+1}}{a_i}$$

du rapport

$$\frac{i_f}{i_i}.$$

Si par contre on prend soin de choisir au départ le gain $g_{i+1}$, la valeur de S associée à $i_i$ sera $a_{i+1}$ et aucune erreur de changement de gain n'affectera la mesure

$$\frac{b_{i+1}}{a_{i+1}}$$

du rapport

$$\frac{i_f}{i_i}.$$

Il faut également prévoir le cas d'une réaction se traduisant par une diminution du signal ($i_f < i_i$), qui, par un raisonnement symétrique, conduit à préférer $g_{i+1}$ à $g_{i+2}$ comme gain initial de mesure de $i_i$. Le meilleur choix est donc d'effectuer la mesure initiale sur le gain intermédiaire parmi les trois gains possibles, ce qui assure une mesure sans nécessité de changement de gain pendant tout le cours de la réaction pour des réactions de faibles amplitudes caractérisées par

$$\frac{1}{2} < \frac{i_f}{i_i} < 2.$$

Le choix de ce gain intermédiaire peut être facilement accompli par le calculateur $\mu$P au moment où la réaction commence à se dérouler.

Pour illustrer les applications des dispositifs conformes à l'invention, on va se référer ci-dessous aux appareillages dans lesquels un échantillon liquide est réparti entre une série de cellules contenant chacune un réactif ou mélange réactionnel et, par exemple, disposées à la périphérie d'un rotor pour venir chacune se présenter dans le faisceau du système optique représenté à la figure 5.

La lampe 1 émet un faisceau lumineux vers une optique 2, un disque 3 portant des filtres 4 pouvant, par rotation grâce à un moteur 5, intercaler un filtre 4 sur le trajet du faisceau pour assurer le monochromatisme ou occulter complètement le faisceau lumineux en vue d'une mesure de noir (de zéro). A la sortie de l'optique 2, le faisceau est concentré sur la cellule d'analyse 6 et la lumière non absorbée tombe sur le détecteur D suivi du préamplificateur PA, de l'amplificateur A et des autres éléments de la figure 2.

Les cellules 6 sont montrées sur le rotor 7 entraîné par le moteur 8, l'ensemble 6-7 pouvant être placé dans une enceinte thermostatée 9.

Le microprocesseur µP gère l'ensemble des opérations : commande de la rotation du moteur 8 du rotor 7 et mise en place des cellules 6, commande de la rotation du moteur 5 du disque 3 et mise en place des filtres 4 pour chaque cellule, exécution des mesures avec changement de gain si la limite due à la saturation ou au manque de résolution est atteinte (figure 6). Le calculateur µP peut également sélectionner à intervalle régulier une position particulière du disque 3 qui occulte le faisceau lumineux et permet une mesure périodique d'un signal de noir destiné à corriger par le calcul une dérive éventuelle de zéro.

Ce microprocesseur µP assure en particulier le calcul des concentrations à partir des mesures photométriques sur la base de la loi de Beer Lambert. Les coefficients d'extinction moléculaire peuvent d'ailleurs être en mémoire morte ou vive.

La température de l'enceinte 9 est également contrôlée par le microprocesseur µP grâce à la sonde thermique 10 et à une ou plusieurs sources de réajustement de température.

Les interfaces adéquats sont prévus entre microprocesseur µP et moteurs 5 et 8, sonde 10 et dispositifs de régulation de température.

De son côté le microprocesseur est relié à une mémoire interne IM de préférence en partie morte (transformation logarithmique) et en partie vive (mesures et autoétalonnage), ainsi qu'à une mémoire morte externe EM, par exemple une cassette, carte ou autre support de type EPROM, qui contient les indications propres au type de mesure à effectuer (disque 7 et cellules 6, disque 3 et filtres 4). Le microprocesseur µP est connecté à divers appareillages via des interfaces IF : clavier d'entrée K, affichage alphanumérique AN, imprimante PR, bus de connection entrée/sortie I/O vers d'autres équipements.

## Revendications

1. Dispositif d'amplification, de conversion analogique/numérique et de calcul transformant des signaux analogiques en signaux logarithmiques numériques comprenant un amplificateur linéaire à gain programmable (A) suivi d'un convertiseur analogique/numérique (CA/N) et d'un calculateur (µP) ledit calculateur (µP) assurant la transformation logarithmique du signal de sortie du convertiseur analogique/numérique (CA/N) et modifiant le gain de l'amplificateur (A) dès que le signal de sortie de ce dernier atteint les limites de saturation ou de résolution acceptable du convertisseur A/N caractérisé en ce qu'il comporte un système générateur de tensions de référence V connectable par le calculateur (µP) à l'entrée de l'amplificateur (A) entre chaque phase de fonctionnement ou à chaque changement de gain, les signaux de sortie dudit amplificateur (A), résultant de la tension de référence V et des gains successifs $g_i$, $g_{i+1}$, et les rapports $Vg_i/Vg_{i+1}$ calculés par le calculateur (µP) étant mis en mémoire à titre d'autoétalonnage pour corriger les mesures pendant la phase de fonctionnement.

2. Dispositif selon la revendication 1 caractérisé par le fait que les tensions de référence sont définies par un diviseur de tension $D_V$ dont l'atténuation est sélectionnée par le calculateur (µP) pendant les phases d'amplification.

3. Dispositif selon la revendication 1 ou 2 caractérisé par le fait que le calculateur (µP) commande des commutateurs électroniques de sélection des gains de l'amplificateur (A), sélectionnant des résistances ($R_G$).

4. Dispositif selon l'une des revendications 2 ou 3 caractérisé par le fait que le calculateur commande des commutateurs électroniques de sélection des atténuations du diviseur de tension $D_V$.

5. Dispositif selon l'une des revendications 1 à 3 caractérisé par le fait que l'ensemble est précédé d'un préamplificateur (PA) recevant les signaux à traiter.

6. Dispositif selon l'une des revendications 1 à 5 caractérisé par le fait qu'un filtre (F) passe-bas est intercalé entre amplificateur et convertisseur.

7. Application du dispositif selon l'une des revendications 1 à 6 caractérisée par le fait que les signaux sont émis par un détecteur-capteur (D) recevant le flux lumineux transmis par un échantillon (2) à analyser à partir d'une source lumineuse (1).

8. Application du dispositif selon la revendication 7 caractérisée par le fait qu'un filtre monochromatique (4) est intercalé sur le trajet lumineux.

9. Application selon la revendication 7 caractérisée par le fait que le dispositif mesure successivement la lumière transmise par un échantillon à étudier et une référence.

10. Application selon l'une des revendications 7 ou 9 caractérisée par le fait qu'une série d'échantillons (2) sont intercalés successivement sur le trajet lumineux sous la commande du calculateur ($\mu$P).

11. Application selon l'une des revendications 7 à 10 caractérisée par le fait qu'une série de filtres (4) sont intercalés sur le trajet lumineux sous la commande du calculateur ($\mu$P).

12. Application selon l'une des revendications 7 à 11 caractérisée par le fait que, sur la commande du calculateur $\mu$P, une disque (3) occulte momentanément le faisceau lumineux.

**Claims**

1. Device for amplifying analogue/digital conversions and calculations converting analogue signals into digital logarithmic signals, comprising a linear amplifier with a programmable output (A) followed by an analogue/digital convertor (CA/N) and by a calculator ($\mu$P), the said calculator ($\mu$P) converting the output signal of the analogue/digital convertor (CA/N) and adjusting the gain of the amplifier (A) as soon as the output signal reaches the acceptable saturation limits of the resolution limits of the A/D convertor, characterised in that it comprises a reference voltage generator system which may be connected by the calculator ($\mu$P) at the input of the amplifier (A) between each operating phase or at each alteration in the gain, the output signals of the said amplifier (A) resulting from the reference voltage V, and from successive gains $g_i$, $g_{i+1}$, and the ratios $Vg_i/Vg_{i+1}$ calculated by the calculator ($\mu$P) being memorised as a means of self-checking to correct the measurements during the operating phase.

2. Device according to Claim 1, characterised in that the reference voltages are defined by a voltage divider $D_v$, the attenuation of which is selected by the calculator ($\mu$P) during the amplification phases.

3. Device according to Claim 1 or 2, characterised in that the calculator ($\mu$P) controls the electronic commutators selecting the gains of the amplifier (A) selecting the resistances ($R_G$).

4. Device according to one of Claims 2 or 3, characterised in that the calculator controls the electronic attenuation selection commutators of the voltage divider $D_v$.

5. Device according to one of Claims 1 to 3, characterised in that the assembly is preceded by a preamplifier (PA) receiving the signals to be processed.

6. Device according to one of Claims 1 to 5, characterised in that a low pass filter (F) is positioned between the amplifier and the convertor.

7. Application of the device according to one of Claims 1 to 6, characterised in that the signals are emitted by a detecting sensor (D) which receives the luminous flux transmitted by a sample (2) which is to be analysed using a light source (1).

8. Application of the device according to Claim 7, characterised in that a monochromatic filter (4) is intercalated in the light path.

9. Application according to Claim 7, characterised in that the device measures, successively, the light transmitted by a sample to be studied and a reference.

10. Application according to one of Claims 7 or 9, characterised in that a series of samples (2) are intercalated successively on the light path under the control of the calculator ($\mu$P).

11. Application according to one of Claims 7 to 10, characterised in that a series of filters (4) are intercalated in the light path under the control of the calculator ($\mu$P).

12. Application according to one of Claims 7 to 11, characterised in that, controlled by the calculator ($\mu$P), a disc (3) momentarily conceals the light beam.

**Patentansprüche**

1. Vorrichtung zur Verstärkung, Analog-Digital-Umwandlung und zur Berechnung, die analoge Signale in logarithmische digitale Signale umwandelt, mit einem linearen Verstärker mit programmierbarer Verstärkung (A) gefolgt von einem Analog-Digital-Wandler (CA/N) und einem Rechner ($\mu$P), wobei der Rechner ($\mu$P) die logarithmische Umwandlung des Ausgangssignals des Analog-Digital-Wandlers (CA/N) sicherstellt und die Verstärkung des Verstärkers (A) modifiziert, sobald das Ausgangssignal des letzteren die Grenzen der Sättigung oder der annehmbaren Auflösung des Analog-Digital-Wandlers A/D erreicht, dadurch gekennzeichnet, daß sie ein Bezugsspannungserzeugungssystem aufweist, das durch den Rechner ($\mu$P) zwischen jeder Betriebsphase oder bei jeder Verstärkungsänderung mit dem Eingang des Verstärkers (A) verbindbar ist, wobei die Ausgangssignale dem Verstärkers (A), die sich aus der Bezugsspannung V und den aufeinanderfolgenden Verstärkungen $g_i$, $g_{i+1}$ ergeben, und die von dem Rechner ($\mu$P) berechneten Verhältnisse $Vg_i/Vg_{i+1}$ zum Selbstabgleich in den Speicher gegeben werden, um die Messungen während der Betriebsphase zu korrigieren.

2. Vorrichtung nach Anspruch 1, dadurch gekennzeichnet, daß die Bezugsspannungen von einem Spannungsteiler $D_v$ bestimmt sind, dessen Dämpfung während der Verstärkungsphasen von dem Rechner ($\mu$P) ausgewählt wird.

3. Vorrichtung noch Anspruch 1 oder 2, dadurch gekennzeichnet, daß der Rechner ($\mu$P) elektronische Umschalter zur Auswahl der Verstärkungen des Verstärkers (A) steuert, indem er Widerstände ($R_G$) auswählt.

4. Vorrichtung nach Anspruch 2 oder 3, dadurch gekennzeichnet, daß der Rechner elektronische Umschalter zur Auswahl der Dämpfungen des Spannungsteilers $D_v$ steuert.

5. Vorrichtung noch einem der Ansprüche 1 bis 3, dadurch gekennzeichnet, daß sich vor der Anordnung ein Vorverstärker (PA) befindet, der die zu verarbeitenden Signale empfängt.

6. Vorrichtung nach einem der Ansprüche 1 bis 5, dadurch gekennzeichnet, daß zwischen dem Verstärker und dem Wandler ein Tiefpaßfilter (F) eingesetzt ist.

7. Verwendung der Vorrichtung nach einem der Ansprüche 1 bis 6, dadurch gekennzeichnet, daß die Signale von einem Detektor-Sensor (D) emittiert werden, der den von einer Lichtquelle (1) aus durch eine zu analysierende Probe (2) durchgelassenen Lichtstrom empfängt.

8. Verwendung der Vorrichtung nach Anspruch 7, dadurch gekennzeichnet, daß ein monochromatisches Filter (4) in den Lichtweg eingesetzt ist.

9. Verwendung noch Anspruch 7, dadurch gekennzeichnet, daß die Vorrichtung nacheinander das durch eine zu untersuchende Probe und ein Bezugsstück durchgelassene Licht mißt.

10. Verwendung nach Anspruch 7 oder 9, dadurch gekennzeichnet, daß eine Reihe von Proben (2) nacheinander in den Lichtweg unter der Steuerung des Rechners ($\mu$P) eingesetzt sind.

11. Verwendung nach einem der Ansprüche 7 bis 10, dadurch gekennzeichnet, daß eine Reihe von Filtern (4) in den Lichtweg unter der Steuerung des Rechners ($\mu$P) eingesetzt sind.

12. Verwendung nach einem der Ansprüche 7 bis 11, dadurch gekennzeichnet, daß auf die Steuerung des Rechners $\mu$P hin eine Scheibe (3) kurzzeitig das Lichtbündel verdunkelt.

EP 0 201 415 B1

FIG.1

FIG.2

FIG.3

FIG.4

FIG.5

FIG.6